# EUROPÄISCHE PATENTANMELDUNG

(11) **EP 1 079 467 A1**
(43) Veröffentlichungstag der Anmeldung: **28.02.2001**
(21) Anmeldenummer: 00117742.7
(22) Anmeldetag: 17.08.2000
(51) Int. Cl.: H01R 12/20

(54) **Zur Montage auf einer Leiterplatte ausgelegtes Bauteil**

(30) Priorität: 20.08.1999 DE 19939581
(71) Anmelder: Tyco Electronics Logistics AG, 9323 Steinach / SG (CH)
(72) Erfinder: Vanbesien, Johan, 8902 Ieper (BE)
(74) Vertreter: Hirsch, Peter

(57) **Zusammenfassung**

Das beschriebene Bauteil umfaßt eine Verankerungsvorrichtung, durch welche das Bauteil mechanisch mit der Leiterplatte verbindbar ist. Die Verankerungsvorrichtung ist so ausgebildet und angeordnet, daß sie an einer unter dem Bauteil liegenden Stelle mit der Leiterplatte verlötbar ist. Dadurch kann das Bauteil ohne Größenzunahme und ohne Einschränkung der Gestaltungsfreiheit im Bauteil- und Schaltungsentwurf fest mit der Leiterplatte verbunden werden.

## Beschreibung

Die vorliegende Erfindung betrifft eine Vorrichtung gemäß dem Oberbegriff des Patentanspruchs 1, d.h. ein zur Montage auf eine Leiterplatte ausgelegtes Bauteil, mit Anschlußelementen, durch welche das Bauteil zumindest elektrisch mit der Leiterplatte verbindbar ist, und mit einer Verankerungsvorrichtung, durch welche das Bauteil mechanisch mit der Leiterplatte verbindbar ist.

Bauteile dieser Art sind in einer Vielzahl von Ausführungsformen bekannt. Dabei handelt es sich insbesondere um mechanisch beanspruchte Bauteile wie beispielsweise elektrische Verbinder.

Die Anschlußelemente, durch welche die betreffenden Bauteile zumindest elektrisch mit der Leiterplatte verbunden werden, sind dabei häufig Anschlußelemente, die dazu ausgelegt sind, nach einem SMT-Lötverfahren mit der Leiterplatte verlötet zu werden.

Insbesondere bei derart ausgebildeten, aber auch bei andersartigen Anschlußelementen besteht die Gefahr, daß diese sich bei einer starken mechanischen Beanspruchung des Bauteils (bei einer Bewegung des Bauteils relativ zur Leiterplatte, beispielsweise beim Einstecken eines elektrischen Verbinders in einen auf der Leiterplatte montierten elektrischen Verbinder) von der Leiterplatte ablösen, wodurch der elektrische Kontakt zu dieser zeitweise oder dauerhaft unterbrochen oder zumindest verschlechtert wird.

Zur Vermeidung dessen sind solche Bauteile zum Teil mit Verankerungsvorrichtungen ausgestattet, durch welche sie mechanisch so fest mit der Leiterplatte verbunden werden sollen, daß eine Bewegung relativ zur Leiterplatte ausgeschlossen oder zumindest erheblich eingeschränkt ist.

Ein Beispiel für eine derartige Verankerungsvorrichtung sind am betreffenden Bauteil vorgesehene Rasthaken, welche bei der Montage des Bauteils auf die Leiterplatte mit zugeordneten Rastelementen der Leiterplatte (beispielsweise mit in der Leiterplatte vorgesehenen Ausnehmungen) verrasten. Derartige und ähnliche Verankerungsvorrichtungen verbinden das Bauteil und die Leiterplatte jedoch nicht vollkommen fest miteinander. Es ist immer ein gewisses Spiel vorhanden, wodurch Bewegungen des Bauteils relativ zur Leiterplatte nicht gänzlich ausgeschlossen sind. Selbst sehr kleine Bewegungsfreiheiten können mit der Zeit zu einer Ablösung der Anschlußelemente des Bauteils von der Leiterplatte führen.

Es gibt bereits Verankerungsvorrichtungen, die diesen Nachteil nicht aufweisen. Solche Verankerungsvorrichtungen sind beispielsweise Bügel oder dergleichen Haltemechanismen, die mit der Leiterplatte verschraubt oder verlötet werden. Verankerungsvorrichtungen dieser Art sind beispielsweise aus der GB 2 300 313 A, der US 5 541 384 und der DE 197 43 251 C1 bekannt. Wie aus den genannten Druckschriften ersichtlich ist, vergrößern solche Verankerungsvorrichtungen die diese enthaltenden Bauteile und/oder schränken die Gestaltungsfreiheit beim Bauteil- und/oder Schaltungsentwurf ein (beispielsweise können solche Bauteile nicht unmittelbar nebeneinander angeordnet werden).

Aus der EP 0 532 974 ist ein auf einer Leiterplatte befestigtes Bauteil in Form eines Steckverbinders bekannt, bei dem in Verlängerung von Seitenwänden des quaderförmigen Bauteils Füße ausgebildet sind, welche in Bohrungen der Leiterplatte hineinragen. Die unteren Enden der Füße sind aufgetrennt, ein Teil ist zur Ausbildung eines unter die Leiterplatte schnappenden Rasthakens abgeknickt, ein anderer Teil verläuft glatt durch die Bohrung der Leiterplatte und wird mit von dem Grundriß des Bauteils nach außen weggehenden Leiterbahnen über angeschmolzene Lötpaste elektrisch und mechanisch verbunden. Auch dieses Bauteil verbietet eine kompakte Aneinanderreihung mehrerer Bauteile auf der Leiterplatte, da die mechanische/elektrische Verbindung ein beträchtliches Stück über den Umriß des Bauteils nach außen wegführt.

Aus der DE 36 37 190 A1 ist ein auf einer Leiterplatte durch Rastfüße verankertes Bauteil bekannt. Die Rastfüße können außerhalb des eigentlichen Bauteils, jedoch auch in dem Umriß des Bauteils integriert sein (Spalte 4, Zeilen 31-37) . Die Besonderheit dieses bekannten Bauteils besteht in der teilhülsenförmigen Ausbildung der auf der Unterseite der Leiterplatte abstehenden Rastfüße. Durch Einfädeln eines Werkzeugs an der Oberseite (an dem Bauteil vorbei) wird das hülsenförmige Ende des in die Leiterplatte eingesteckten Fußes aufgeweitet und hat damit eine größere Abmessung als der Durchmesser des in der Leiterplatte befindlichen Aufnahmelochs.

Aus der DE 197 43 251 C1 ist ein zur Montage auf einer Leiterplatte ausgelegtes Bauteil bekannt, bei dem unterhalb des Bauteils Verankerungselemente vorgesehen sind, von denen nach außen über den Umriß des Bauteils hinaus Fortsätze abstehen, die über Lötpaste mit der Oberseite einer Leiterplatte verbunden werden.

Der vorliegenden Erfindung liegt daher die Aufgabe zugrunde, das Bauteil gemäß dem Oberbegriff des Patentanspruchs 1 derart weiterzubilden, daß dieses durch eine das Bauteil nicht oder jedenfalls nicht nennenswert vergrößernde und die Gestaltungsfreiheit beim Bauteil- und/oder Schaltungsentwurf nicht oder jedenfalls nicht nennenswert einschränkende Verankerungsvorrichtung derart mit der Leiterplatte verbindbar ist, daß die elektrische Verbindung zwischen dem Bauteil und der Leiterplatte beeinträchtigende Bewegungen des Bauteils relativ zur Leiterplatte zuverlässig und dauerhaft ausgeschlossen sind.

Diese Aufgabe wird erfindungsgemäß durch die im kennzeichnenden Teil des Patentanspruchs 1 beanspruchten Merkmale gelöst.

Demnach ist vorgesehen, daß die Verankerungsvorrichtung so ausgebildet und angeordnet ist, daß sie an einer unter dem Bauteil liegenden Stelle mit der Leiterplatte verlötbar ist.

Eine derart ausgebildete und angeordnete Verankerungsvorrichtung macht das Bauteil weder größer, noch beeinträchtigt sie die Gestaltungsfreiheit beim Bauteil- und/oder Schaltungsentwurf. Andererseits kann durch eine Verankerungsvorrichtung dieser Art zuverlässig gewährleistet werden, daß die elektrische Verbindung zwischen dem Bauteil und der Leiterplatte beeinträchtigende Bewegungen des Bauteils relativ zur Leiterplatte zuverlässig und dauerhaft ausgeschlossen sind.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: eine Seitenansicht eines nachfolgend näher beschriebenen elektrischen Verbinders,
- Figur 2: eine Frontansicht des elektrischen Verbinders gemäß Figur 1,
- Figur 3: eine teilweise geschnittene Seitenansicht des elektrischen Verbinders gemäß den Figuren 1 und 2,
- Figur 4: eine Seitenansicht eines gegenüber dem elektrischen Verbinder gemäß dem Figuren 1 bis 3 modifizierten elektrischen Verbinders,
- Figur 5: eine Frontansicht des elektrischen Verbinders gemäß Figur 4, und
- Figur 6: eine geschnittene Seitenansicht des elektrischen Verbinders gemäß den Figuren 4 und 5.

Bei dem Bauteil, anhand dessen die Erfindung nachfolgend näher beschrieben wird, handelt e sich um einen elektrischen Verbinder. Es sei jedoch bereits an dieser Stelle darauf hingewiesen, daß die nachfolgend näher beschriebenen Besonderheiten des elektrischen Verbinders auch bei anderen Bauteilen vorgesehen werden können.

Der betrachtete elektrische Verbinder besteht aus einem vorderen Abschnitt V und einem hinteren Abschnitt H und ist dazu ausgelegt, nur mit dem hinteren Abschnitt H auf eine Leiterplatte LP aufgesetzt zu werden; der vordere Abschnitt V steht im auf die Leiterplatte aufgesetzten Zustand des elektrischen Verbinders seitlich über die Leiterplatte LP über. Allerdings besteht hierauf keine Einschränkung. Die nachfolgend näher beschriebenen Besonderheiten des elektrischen Verbinders können auch bei Bauteilen vorgesehen werden, die nicht über die Leiterplatte überstehen.

Der betrachtete elektrische Verbinder besteht im wesentlichen aus Kontaktelementen 1, einem diese beherbergenden Gehäuse 2, aus dem Gehäuse 2 herausgeführten elektrischen Anschlußelementen 3, einer die Anschlußelemente 3 in einer vorbestimmten Relativiage fixierenden Ausrichtplatte 4, und eine Verankerungsvorrichtung 5.

Die Kontaktelemente 1 dienen zum Verbinden des elektrischen Verbinders mit einem anderen elektrischen Verbinder. Solche Kontaktelemente sind bekannt und bedürfen keiner näheren Erläuterung.

Die Anschlußelemente 3 dienen zur elektrischen Verbindung des elektrischen Verbinders mit der Leiterplatte LP. Im betrachteten Beispiel handelt es sich um zur Oberflächenmontage des elektrischen Verbinders auf die Leiterplatte ausgelegte SMT-Kontakte.

Es sei jedoch bereits an dieser Stelle darauf hingewiesen, daß sich das Vorsehen der nachfolgend näher beschriebenen Besonderheiten auch als vorteilhaft erweist, wenn das Bauteil anders (durch ein anderes Lötverfahren oder in sonstiger Weise) elektrisch mit der Leiterplatte verbunden wird.

Die Ausrichtplatte 4 dient, wie vorstehend bereits erwähnt wurde, zum Fixieren der Anschlußelemente 3 in einer vorbestimmten Relativlage. Bezüglich weiterer Einzelheiten zur Ausrichtplatte 4 wird auf die DE 197 54 877 A1 verwiesen.

Die Verankerungsvorrichtung 5 dient dazu, den elektrischen Verbinder mechanisch fest mit der Leiterplatte zu verbinden. Durch sie wird erreicht, daß die elektrische Verbindung zwischen dem elektrischen Verbinder und der Leiterplatte (die Verbindungen zwischen den Anschlußelementen 3 und der Leiterplatte LP) beeinträchtigende Bewegungen des elektrischen Verbinders relativ zur Leiterplatte zuverlässig und dauerhaft ausgeschlossen sind.

Die Verankerungsvorrichtung 5 wird im betrachteten Beispiel durch einen aus Metall oder Metall enthaltendem Material bestehenden, plattenartigen Körper mit an einer verbreiterten Stelle nach unten gebogenen Randabschnitten gebildet. Sie ist am Gehäuse 2 oder einem anderen Bestandteil des elektrischen Verbinders befestigt und weist einen zum Verlöten mit der Leiterplatte LP ausgelegten Teil auf.

Im betrachteten Beispiel erfolgt die Befestigung der Verankerungsvorrichtung 5 am Gehäuse 2 durch ein teilweises Eingießen der Verankerungsvorrichtung 5 in das Gehäuse 2. Der nicht eingegossene Teil der Verankerungsvorrichtung läuft im betrachteten Beispiel an der Unterseite des Gehäusebodens entlang und bildet zumindest teilweise den zum Verlöten mit der Leiterplatte ausgelegten Teil der Verankerungsvorrichtung.

Der zum Verlöten mit der Leiterplatte ausgelegte Teil der Verankerungsvorrichtung 5 ist ein an der Unterseite des Bodens des Gehäuses 2 entlanglaufender, sich im wesentlichen über die ganze Breite des elektrischen Verbinders erstreckender Streifen. Durch die Anordnung und Ausbildung des zum Verlöten mit der Leiterplatte ausgelegten Teils der Verankerungsvorrichtung 5 kann diese an einer unter dem elektrischen Verbinder liegenden Stelle mit der Leiterplatte verlötet werden.

Insbesondere wenn der elektrische Verbinder wie im betrachteten Beispiel ein zur Oberflächenmontage ausgelegter elektrischer Verbinder ist, ist die Verankerungsvorrichtung 5 vorzugsweise ebenfalls dazu ausgelegt, nach einem SMT-Verfahren mit der Leiterplatten-Oberfläche verbunden zu werden. Dies ist im betrachteten Beispiel auch der Fall. Allerdings besteht hierauf keine Einschränkung. Die Verankerungsvorrichtung kann grundsätzlich auch nach einem beliebigen anderen Verfahren mit der Leiterplatte verlötet werden.

Falls die Verankerungsvorrichtung 5 wie im betrachteten Beispiel nach einem SMT-Verfahren mit der Leiterplatte zu verlöten ist, kann dies beispielsweise unter Verwendung der sogenannten BGA (Ball-Grid-Array)-Technologie oder der sogenannten PSGA (Plastic-Stud-Grid-Array)-Technologie erfolgen.

Durch das Vorsehen und Verlöten der Verankerungsvorrichtung 5 unter dem elektrischen Verbinder wird dieser nicht oder jedenfalls nicht nennenswert größer als ein keine Verankerungsvorrichtung aufweisender elektrischer Verbinder. Größer kann allenfalls dessen Höhe werden, und dies ist im allgemeinen unkritisch und stört nicht. Darüber hinaus wird durch die wie beschrieben ausgebildete und angeordnete Verankerungsvorrichtung auch nicht die Gestaltungsfreiheit beim Bauteil- und/oder Schaltungsentwurf beeinträchtigt: vor, seitlich und hinter dem Bauteil müssen keine Verankerungsvorrichtungen angeordnet und/oder mit der Leiterplatte in Verbindung gebracht werden.

Dadurch ist es beispielsweise möglich, einen großen (viele Kontaktelemente umfassenden) elektrischen Verbinder aus einer Vielzahl von unmittelbar nebeneinandergesetzten kleinen (weniger Kontaktelemente umfassenden) elektrischen Verbindern zu bilden. Dies erweist sich als vorteilhaft, weil große elektrische Verbinder insbesondere dann, wenn es sich um oberflächenmontierbare Bauteile handelt, nicht ohne weiteres in guter Qualität hergestellt und montiert werden können: einerseits ist es schwierig, die vorhandenen Anschlußelemente wie für die Oberflächenmontage gefordert exakt koplanar auszurichten, und andererseits können Leiterplatten-Unebenheiten nicht oder allenfalls sehr begrenzt kompensiert werden. Diese Probleme lassen sich bei kleineren elektrischen Verbindern vergleichsweise leicht lösen oder kompensieren.

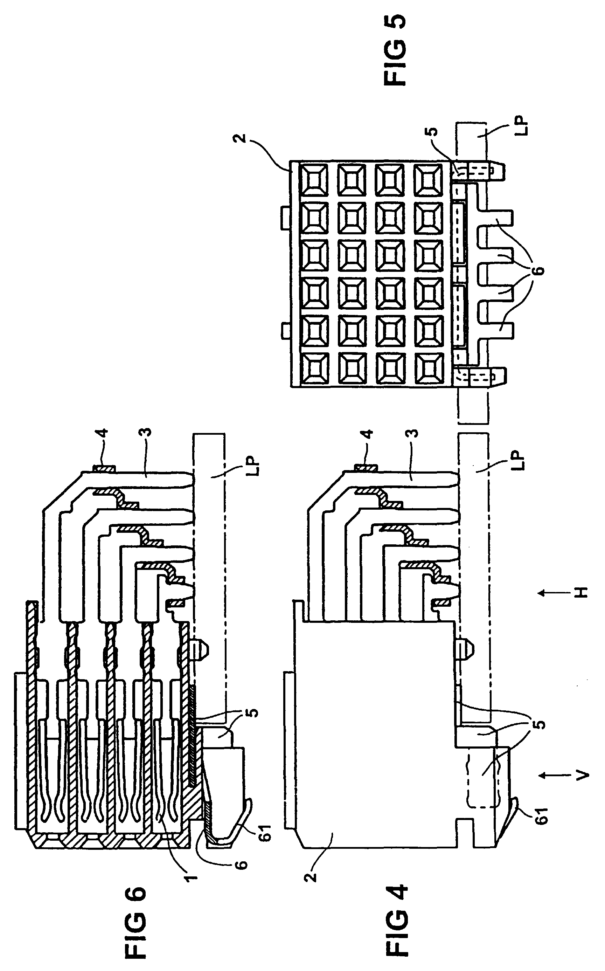

Der Verankerungsvorrichtung 5 kann durch eine entsprechende Ausbildung derselben eine Doppelfunktion übertragen werden: sie kann bei entsprechender Ausbildung zugleich als ein oder mehrere Abschirmkontaktelemente wirken, die mit zugeordneten Kontaktelementen eines mit dein elektrischen Verbinder in Kontakt zu bringenden anderen elektrischen Verbinders in Kontakt gebracht werden können. Ein elektrischer Verbinder mit einer solchen Verankerungsvorrichtung ist in den Figuren 4 bis 6 dargestellt.

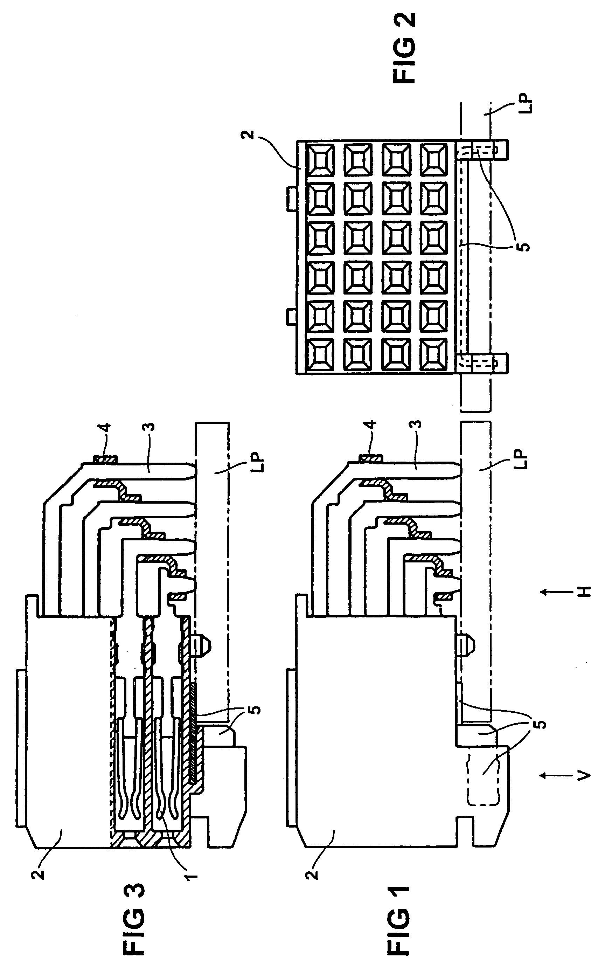

Der in den Figuren 4 bis 6 dargestellte elektrische Verbinder entspricht bis auf die Verankerungsvorrichtung 5 dem in den Figuren 1 bis 3 gezeigten elektrischen Verbinder; mit den selben Bezugszeichen bezeichnete Elemente sind einander entsprechende Elemente.

Die vorstehend zur Verankerungsvorrichtung 5 gemachten Ausführungen haben auch für die beim elektrischen Verbinder gemäß den Figuren 4 bis 6 vorgesehene Verankerungsvorrichtung Gültigkeit. Die Verankerungsvorrichtung des elektrischen Verbinders gemäß den Figuren 4 bis 6 unterscheidet sich von der Verankerungsvorrichtung des elektrischen Verbinders gemäß den Figuren 1 bis 3 "nur" dadurch, daß die Verankerungsvorrichtung des elektrischen Verbinders gemäß den Figuren 4 bis 6 mit dem Bezugszeichen 6 bezeichnete Ausläufer aufweisen, die sich - durch das Verbindergehäuse hindurch und/oder innen oder außen am Verbindergehäuse entlang laufend - wie in den Figuren 4 bis 6 gezeigt oder ähnlich in den vorderen Abschnitt V des elektrischen Verbinders erstrecken. Die Endabschnitte 61 der Ausläufer 6 sind frei zugängliche Abschnitte der Ausläufer und sind als Kontaktelemente ausgebildet, die mit zugeordneten Kontaktelementen eines mit dem betrachteten elektrischen Verbinder in Kontakt zu bringenden elektrischen Verbinders in Kontakt gebracht werden können.

Die durch die Verankerungsvorrichtung gebildeten bzw. von dieser abgehenden Kontaktelemente werden vorzugsweise als Abschirmkontakte verwendet, durch welche eine an den elektrischen Verbindern oder Verbindungsleitungen vorgesehene Abschirmeinrichtung zur Abschirmung elektromagnetischer Strahlen auf ein bestimmtes Potential (vorzugsweise Massepotential) gebracht werden kann. Die Beaufschlagung der betreffenden Kontaktelemente mit dem vorbestimmten Potential kann über die den elektrischen Verbinder tragende Leiterplatte, genauer gesagt über die Lötstelle erfolgen, durch die die elektrische Leiterplatte und die Verankerungsvorrichtung miteinander verbunden sind.

Selbstverständlich können die durch die Verankerungsvorrichtung gebildeten bzw. von dieser abgehenden Kontaktelemente auch zur Übertragung von für andere Zwecke benötigten Potentialen, Signalen und/oder Daten verwendet werden.

Es dürfte einleuchten, daß insbesondere die Ausbildung der Verankerungsvorrichtung (vor allem deren Größe, deren Form etc.) sowie die Verbindung der Verankerungsvorrichtung mit dem Gehäuse oder anderen Bauteil-Bestandteilen mannigfaltig modifizierbar ist.

Wie beschrieben ausgebildete Bauteile können unabhängig von den Einzelheiten der praktischen Realisierung ohne oder jedenfalls ohne nennenswerte Vergrößerung des Bauteils und ohne oder jedenfalls ohne nennenswerte Einschränkung der Gestaltungsfreiheit beim Bauteil- und/oder Schaltungsentwurf derart mit der Leiterplatte verbunden werden, daß die elektrische Verbindung zwischen dem Bauteil und der Leiterplatte beeinträchtigende Bewegungen des Bauteils relativ zur Leiterplatte zuverlässig und dauerhaft ausgeschlossen sind.

## Patentansprüche

1. Zur Montage auf eine Leiterplatte (LP) ausgelegtes Bauteil, mit Anschlußelementen (3), durch welche das Bauteil zumindest elektrisch mit der Leiterplatte verbindbar ist, und mit einer Verankerungsvorrichtung (5), durch welche das Bauteil mechanisch mit der Leiterplatte verbindbar ist,
**dadurch gekennzeichnet,**
daß die Verankerungsvorrichtung (5) so ausgebildet und angeordnet ist, daß sie an einer unter dem Bauteil liegenden Stelle mit der Leiterplatte (LP) verlötbar ist.

2. Bauteil nach Anspruch 1,
**dadurch gekennzeichnet,**
daß die Verankerungsvorrichtung (5) ein aus Metall oder aus einem Metall enthaltenden Material bestehender Körper ist.

3. Bauteil nach Anspruch 1 oder 2,
**dadurch gekennzeichnet,**
daß die Verankerungsvorrichtung (5) wenigstens in dem Bereich, in welchem sie mit der Leiterplatte (5) zu verbinden ist, plattenförmig ausgebildet ist.

4. Bauteil nach einem der vorhergehenden Ansprüche,
**dadurch gekennzeichnet,**
daß die Verankerungsvorrichtung (5) in dem Bereich, in welchem sie mit der Leiterplatte (LP) zu verbinden ist, an der Unterseite des Bodens eines Bauteil-Gehäuses entlang verläuft.

5. Bauteil nach einem der vorhergehenden Ansprüche,
**dadurch gekennzeichnet,**
daß die Verankerungsvorrichtung (5) durch Einklemmen oder Umspritzen mit einem Gehäuse (2) oder einem anderen Bestandteil des Bauteils verbunden ist.

6. Bauteil nach einem der vorhergehenden Ansprüche,
**dadurch gekennzeichnet,**
daß die Verankerungsvorrichtung (5) dazu ausgelegt ist, nach einem SMT-Lötverfahren mit der Leiterplatte (LP) verlötet zu werden.

7. Bauteil nach einem der vorhergehende Ansprüche,
**dadurch gekennzeichnet,**
daß von der Verankerungsvorrichtung (5) als Kontaktelemente ausgebildete Ausläufer (6) abgehen.
